# EUROPÄISCHE PATENTANMELDUNG

(11) **EP 1 432 298 A2**
(43) Veröffentlichungstag der Anmeldung: **23.06.2004**
(21) Anmeldenummer: 03405817.2
(22) Anmeldetag: 18.11.2003
(51) Int. Cl.: H05K 9/00

(54) **Gehäuse mit Abdeckplatte**

(30) Priorität: 18.12.2002 EP 02406110
(71) Anmelder: ELMA Electronic AG, 8620 Wetzikon (CH)
(72) Erfinder: Hauser, Christoph, 8630 Rüti (CH); Heussi, Georg, 8645 Jona (CH)
(74) Vertreter: Sulzer Management AG

(57) **Zusammenfassung**

Das Gehäuse (1) umfasst eine demontierbare Abdeckplatte (2), die in montiertem Zustand elektrisch leitend mit dem Gehäuse (1) verbunden ist, wobei die Abdeckplatte (2) an deren Peripherie eine oder mehrere seitliche Kontaktflächen (6) aufweist. Zusätzlich umfasst das Gehäuse (1) mindestens ein Formteil (8), welches mit Kontaktstellen (7) versehen ist, die derart ausgebildet und angeordnet sind, dass die Abdeckplatte (2) in montiertem Zustand über die seitlichen Kontaktflächen (6) und die genannten Kontaktstellen (7) elektrisch leitend mit dem Gehäuse (1) verbunden ist.

## Beschreibung

Die Erfindung betrifft ein Gehäuse oder einen Baugruppenträger, welche mindestens eine demontierbare Abdeckplatte umfassen, die zumindest partiell leitend ist und die in montiertem Zustand elektrisch leitend mit dem Gehäuse beziehungsweise Baugruppenträger verbunden ist.

Gehäuse und Baugruppenträger zur Aufnahme elektrischer und elektronischer Komponenten sind normalerweise elektrisch leitend ausgeführt, um eine ausreichende elektromagnetische Abschirmung zu erzielen. Enthält das Gehäuse beziehungsweise der Baugruppenträger eine demontierbare Abdeckplatte, so muss sichergestellt sein, dass die Abdeckplatte in montiertem Zustand elektrisch leitend mit dem Gehäuse beziehungsweise Baugruppenträger verbunden ist. In Dokument EP 0 809 425 A1 wird ein Baugruppenträger für Steckbaugruppen beschrieben, deren Frontplatten mit U-förmigen, nach innen gebogenen Schenkeln versehen sind, um über Federelemente den seitlichen Kontakt mit benachbarten Frontplatten mit U-förmigen Schenkeln oder mit einer seitlichen Begrenzung des Baugruppenträgers herzustellen. Die Federlemente für den seitlichen Kontakt sind als Blattfedern ausgebildet, die aus dem Blech der U-förmigen Schenkel freigeschnitten sind. Die beschriebene Kontaktierung hat den Nachteil, dass für das Lackieren oder Eloxieren der Frontplatten die Kontaktstellen relativ aufwändig abgedeckt werden müssen. Zusätzlich ist die beschriebene Frontplatte lediglich auf der rechten und linken Seite mit Kontaktstellen versehen. Um die elektromagnetische Abschirmung zu verbessern, wäre jedoch eine entsprechende Kontaktierung der Frontplatten auf allen vier Seiten erwünscht. Ein weiterer Nachteil der in EP 0 809 425 A1 beschriebenen Frontplatte besteht darin, dass sich der Einsatz wegen der Biege- und Freistanzoperationen auf Frontplatten aus vergleichsweise dünnem Blech beschränkt.

Aufgabe der vorliegenden Erfindung ist es, ein Gehäuse oder einen Baugruppenträger mit mindestens einer demontierbaren Abdeckplatte zur Verfügung zu stellen, die zumindest partiell leitend ist, die in montiertem Zustand elektrisch leitend mit dem Gehäuse beziehungsweise Baugruppenträger verbunden ist, und die in allen praktisch relevanten Materialstärken herstellbar ist. Weiter soll die Kontaktierung der Abdeckplatte für allseitige Kontaktierung geeignet sein, und die Kontaktstellen an der Abdeckplatte sollen in Hinblick auf allfällige Oberflächenbehandlungen wie Lackieren oder Eloxieren einfach abdeckbar sein.

Diese Aufgabe wird erfindungsgemäss durch das in Anspruch 1 definierte Gehäuse beziehungsweise durch den in Anspruch 1 definierten Baugruppenträger gelöst.

Das erfindungsgemässe Gehäuse oder der erfindungsgemässe Baugruppenträger umfassen mindestens eine demontierbare Abdeckplatte, insbesondere Frontplatte, welche Abdeckplatte zumindest partiell elektrisch leitend ist und welche in montiertem Zustand elektrisch leitend mit dem Gehäuse beziehungsweise Baugruppenträger verbunden ist. Die Abdeckplatte zeichnet sich dadurch aus, dass an deren Peripherie eine oder mehrere seitliche Kontaktflächen vorgesehen sind. Zusätzlich umfasst das Gehäuse beziehungsweise der Baugruppenträger mindestens ein Formteil, welches mit Kontaktstellen versehen ist, die derart ausgebildet und angeordnet sind, dass die Abdeckplatte in montiertem Zustand über die seitlichen Kontaktflächen und die genannten Kontaktstellen elektrisch leitend mit dem Gehäuse beziehungsweise Baugruppenträger verbunden ist.

Vorzugsweise stehen die seitlichen Kontaktflächen im Wesentlichen senkrecht zur Vorder- und Rückseite der Abdeckplatte, und vorzugsweise erstrecken sich die seitlichen Kontaktflächen über die Dicke der Abdeckplatte oder über einen Teil der Dicke der Abdeckplatte.

In einer bevorzugten Ausführungsform ist die Abdeckplatte als plane Platte ausgebildet und in einer weiteren bevorzugten Ausführungsform umfassen das Gehäuse beziehungsweise der Baugruppenträger zusätzlich eine mit einer Vertiefung versehene Umrandung, in welche Vertiefung die Abdeckplatte einsetzbar ist. In einer Ausführungsvariante ist die Abdeckplatte frontal in die Vertiefung einsetzbar.

Vorzugsweise ist die Vorderseite der montierten Abdeckplatte bündig mit der Umrandung oder gegenüber der Umrandung versenkt angeordnet. Vorzugsweise ist das Formteil Teil der Umrandung und/oder als abgewinkeltes Abdeckblech mit Kontaktstellen ausgebildet, und vorzugsweise sind die Kontaktstellen des Formteils federnd ausgebildet sind. In einer Ausführungsvariante sind die Kontaktstellen des Formteils als Noppen und/oder als vorstehende Teile und/oder als vorstehende Teile mit Noppen ausgebildet. In einer weiteren Ausführungsvariante sind die Kontaktstellen des Formteils derart freigestanzt, dass eine Federwirkung erzielt wird.

Das erfindungsgemässe Gehäuse beziehungsweise der erfindungsgemässe Baugruppenträger mit mindestens einer Abdeckplatte haben den Vorteil, dass Abdeckplatten und insbesondere Frontplatten beliebiger Materialstärke verwendet werden können. Die seitliche Kontakflächen an der Peripherie der Abdeckplatte des erfindungsgemässen Gehäuses beziehungsweise Baugruppenträgers erlauben eine einfache Kontaktierung auf allen vier Seiten der Abdeckplatte. Weiter können die seitlichen Kontaktflächen für allfälllige Oberflächenbehandlungen wie beispielsweise Lackieren oder Eloxieren einfach abgedeckt werden. Es ist auch möglich, die seitliche Kontakflächen zu überschleifen, womit sich das Abdecken erübrigt. Eine weitere vorteilhafte Möglichkeit besteht darin, die Abdeckplatte schonend aus einer grösseren Platte oder einem grösseren Blech herauszuschneiden, das bereits oberflächenbehandelt ist, so dass nachträgliche Oberflächenbehandlungen der einzelnen Abdeckplatten gänzlich entfallen können. Dies eröffnet auch die Möglichkeit, Abdeckplatten aus plastifizierten Blechen oder aus einem Metall/Plastikverbund einzusetzen. Vorteilhafterweise können die Kontakstellen an den Formteilen scharfkantig ausgebildet sein, so dass isolierende Oberflächenschichten auf den Kontaktflächen der Abdeckplatte durchtrennt werden, womit sich ein Abdecken oder Überschleifen der seitlichen Kontaktflächen ebenfalls erübrigt. In einer vorteilhaften Ausführungsform ist das Formteil als abgewinkeltes Abdeckblech mit Kontaktstellen ausgebildet, wobei die Kontaktstellen derart freigestanzt sind, dass eine Federwirkung erzielt wird. Bei dieser Ausführungsform entfällt der Aufwand für Herstellung und Montage von separaten Formteilen.

Weitere vorteilhafte Ausführungsformen gehen aus den abhängigen Ansprüchen und der Zeichnung hervor.

Im Folgenden wird die Erfindung an Hand des Ausführungsbeispiels und an Hand der Zeichnung näher erläutert. Es zeigen:
- Fig. 1: eine Schrägansicht eines Ausführungsbeispiels eines Gehäuses gemäss der vorliegenden Erfindung,
- Fig. 2: eine Detailansicht einer Umrandung und Kontaktierung gemäss Ausführungsbeispiel im Schnitt,
- Fig. 3A: eine Schrägansicht einer ersten Ausführungsvariante eines Abdeckbleches mit Kontaktstellen,
- Fig. 3B: eine Schrägansicht einer zweiten Ausführungsvariante eines Abdeckbleches mit Kontaktstellen,
- Fig. 3C: eine Schrägansicht einer dritten Ausführungsvariante eines Abdeckbleches mit Kontaktstellen,
- Fig. 3D: eine Schrägansicht einer vierten Ausführungsvariante eines Abdeckbleches mit Kontaktstellen, und
- Fig. 3E: eine Schrägansicht einer fünften Ausführungsvariante eines Abdeckbleches mit Kontaktstellen.

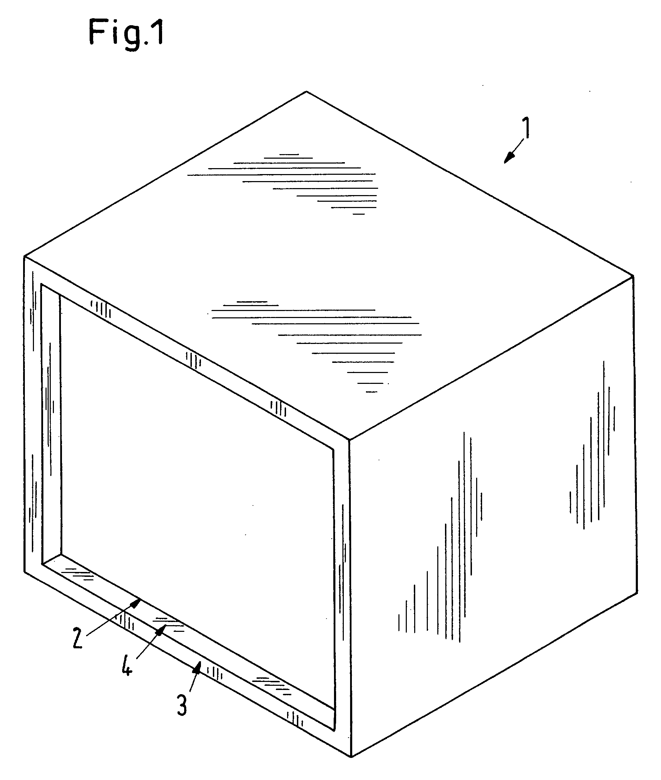

In einem Ausführungsbeispiel, welches in Fig. 1 gezeigt ist, umfasst das erfindungsgemässe Gehäuse eine demontierbare Frontplatte 2, die in bekannter Weise am oder im Gehäuse 1 befestigt ist. Die Frontplatte 2 ist im Ausführungsbeispiel als plane Platte ausgeführt, die beispielsweise aus einem Metallblech, vorzugsweise einem oberflächenbehandelten Metallblech wie z.B. einem lackierten oder galvanisierten Stahlblech oder einem eloxierten Aluminiumblech, oder aus einem anderen elektrisch leitenden Material besteht. Die Platte kann aber auch aus einem plastifizierten Blech, d.h. aus einem Metall/Plastik-Verbund, einer Kunststoffplatte mit leitfähiger Schicht oder einer ähnlichen, zumindest partiell leitenden Materialkombination bestehen. Vorteilhafterweise wird die Frontplatte 2 aus einer grösseren Platte herausgetrennt, die bereits oberflächenbehandelt ist, so dass eine nachträgliche Oberflächenbehandlung der Frontplatte entfällt. Selbstverständlich können auch die Rückwand oder eine oder mehrere Seitenwände als demontierbare Abdeckplatten ausgeführt werden. Im Ausführungsbeispiel umfasst das Gehäuse 1 zusätzlich eine Umrandung 3, die mit einer Vertiefung 4 versehen ist, in welcher die Frontplatte 2 nach erfolgter Montage versenkt angeordnet ist. Andere Anordnungen der Frontplatte, wie z.B. eine Anordnung, in welcher die Vorderseite der montierten Frontplatte 2 bündig ist mit der Vorderkante der Umrandung 3 oder teilweise vorsteht, sind selbstverständlich ebenfalls möglich.

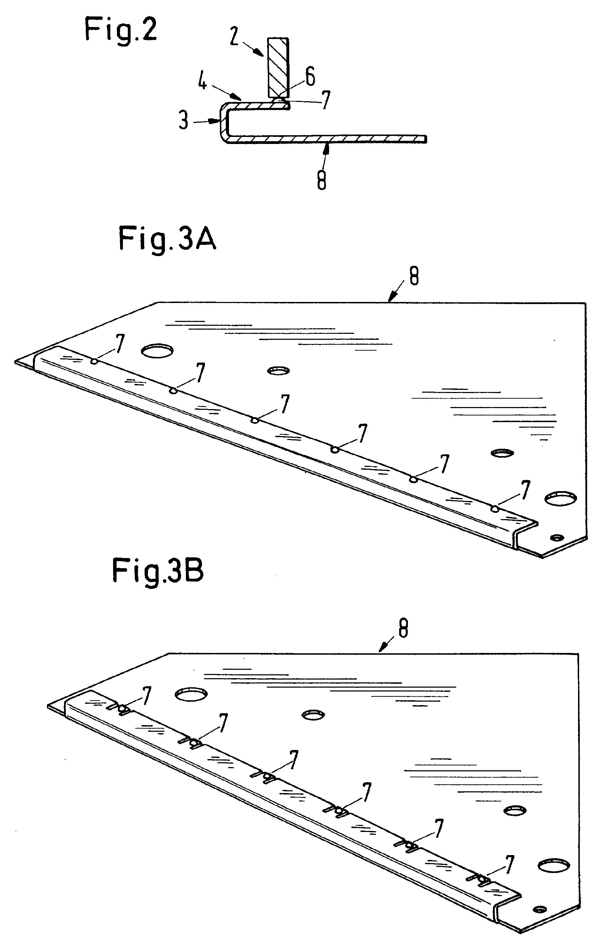

Die Kontaktierung der Frontplatte 2 wird im Folgenden anhand von Fig. 2 näher beschrieben. Zur Kontaktierung weist die Frontplatte 2 an deren Peripherie eine oder mehrere seitliche Kontaktflächen (6) auf, die mit dem Blech oder einer anderen leitenden Schicht der Frontplatte elektrisch leitend verbunden sind. In der gezeigten Ausführungsvariante stehen die seitlichen Kontaktflächen 6 im Wesentlichen senkrecht zur Vorder- und Rückseite der Abdeckplatte 2 und erstrecken sich über die gesamte Plattendicke. Es ist jedoch auch möglich, andere Kontaktflächen beispielsweise nicht plane Kontaktflächen vorzusehen. Weiter umfasst das Gehäuse mindestens ein Formteil 8, das mit Kontaktstellen 7 versehen ist. Im Ausführungsbeispiel umfasst das Formteil 8 ein seitliches Abdeckblech, dessen vorderes Ende U-förmig abgebogen oder abgewinkelt ist, um eine Seite einer Umrandung 3 und einer Vertiefung 4 zu bilden, in welcher die Abdeckplatte 2 versenkt angeordnet ist. Die Kontaktstellen 7 und die Abdeckplatte 2 sind derart in der Vertiefung 4 angeordnet, dass die Abdeckplatte 2 in montiertem Zustand über die seitlichen Kontaktflächen 6 und die Kontaktstellen 7 elektrisch leitend mit dem Gehäuse verbunden ist. Selbstverständlich kann das Gehäuse auch als Baugruppenträger ausgebildet sein.

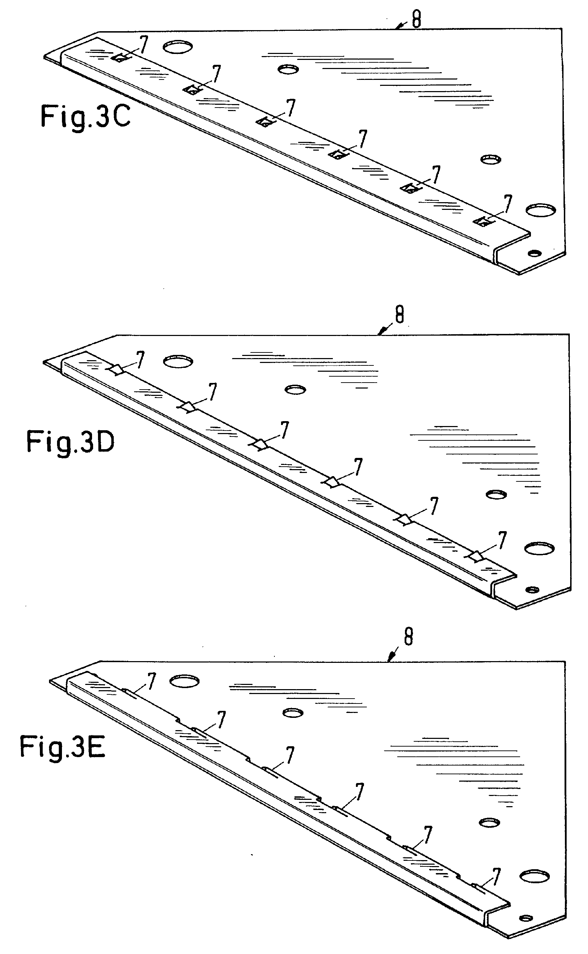

Figuren 3A bis 3E zeigen Ausführungsvarianten eines Abdeckbleches mit Kontaktstellen. In Fig. 3A ist das vordere Ende des Abdeckbleches 8, wie oben stehend beschrieben, U-förmig abgewinkelt. Auf dem nach innen gerichteten Schenkel des Abdeckbleches 8 sind Kontaktstellen 7 in Form von vorstehenden Noppen ausgebildet, die beispielsweise durch Tiefziehen des Abdeckbleches 8 hergestellt werden können. Zweckmässigerweise sind die Kontaktstellen 7 in einer Reihe parallel zur Biegekante des Abdeckbleches 8 angeordnet. Die Abstände zwischen den Kontaktstellen richten sich nach der gewünschten elekromagnetischen Abschirmwirkung. Für elektromagnetische Felder im GHz-Bereich liegen die Abstände in der Grössenordnung von einigen cm und darunter. Die in Fig. 3A gezeigten Kontaktstellen 7 sind federnd angeordnet, wobei die Federwirkung des U-förmig abgewinkelten Abdeckbleches vergleichsweise gering ist. Eine verbesserte Federwirkung lässt sich, wie in Fig. 3B gezeigt, durch Freistanzen der Kontaktstellen erreichen. Abgesehen von den Freistanzungen sind die Kontaktstellen in der in Fig. 3B gezeigten Ausführungsvariante analog ausgebildet und angeordnet wie diejenigen der ersten Ausführungsvariante. Durch eine schmalere und längliche Formgebung der Kontaktstellen 7 kann der Federweg weiter vergrössert werden. Eine entsprechende Ausführungsvariante ist in Fig. 3E dargestellt.

An Stelle von Noppen können an den Kontaktstellen auch andere vorstehende Teile vorgesehen sein. In Fig. 3C sind beispielsweise spitz ausgebildete Kontaktstellen gezeigt und in Fig. 3D sind die Kontaktstellen als Blechlaschen ausgebildet die einseitig hochgebogen sind, so dass eine vorstehende Kante entsteht. Die spitz oder kantig vorstehenden Kontaktstellen haben den Vorteil, dass sie allfällige schlecht oder nicht leitende Oberflächenschichten auf den Kontaktflächen der demontierbaren Abdeckplatte durchdringen können, so dass auch in diesen Fällen ein zuverlässiger Kontakt zwischen Abdeckplatte und Gehäuse erzielt werden kann.

## Patentansprüche

1. Gehäuse oder Baugruppenträger umfassend mindestens eine demontierbare Abdeckplatte (2), insbesondere Frontplatte, welche Abdeckplatte (2) zumindest partiell elektrisch leitend ist und welche in montiertem Zustand elektrisch leitend mit dem Gehäuse (1) beziehungsweise Baugruppenträger (1) verbunden ist, **dadurch gekennzeichnet, dass** die Abdeckplatte (2) an deren Peripherie eine oder mehrere seitliche Kontaktflächen (6) aufweist und das Gehäuse (1) beziehungsweise der Baugruppenträger (1) mindestens ein Formteil (8) umfasst, welches mit Kontaktstellen (7) versehen ist, die derart ausgebildet und angeordnet sind, dass die Abdeckplatte (2) in montiertem Zustand über die seitlichen Kontaktflächen (6) und die genannten Kontaktstellen (7) elektrisch leitend mit dem Gehäuse (1) beziehungsweise Baugruppenträger (1) verbunden ist.

2. Gehäuse oder Baugruppenträger nach Anspruch 1, wobei die seitlichen Kontaktflächen (6) im Wesentlichen senkrecht stehen zur Vorder- und Rückseite der Abdeckplatte (2).

3. Gehäuse oder Baugruppenträger nach einem der Ansprüche 1 oder 2, wobei sich die seitlichen Kontaktflächen (6) über die Dicke der Abdeckplatte (2) erstrecken oder über einen Teil der Dicke der Abdeckplatte.

4. Gehäuse oder Baugruppenträger nach einem der vorangehenden Ansprüche, wobei die Abdeckplatte (2) als plane Platte ausgebildet ist.

5. Gehäuse oder Baugruppenträger nach einem der vorangehenden Ansprüche, wobei das Gehäuse beziehungsweise der Baugruppenträger zusätzlich eine mit einer Vertiefung (4) versehene Umrandung (3) umfasst, in welche Vertiefung (4) die Abdeckplatte (2) einsetzbar ist, und wobei die Abdeckplatte (2) insbesondere frontal in die Vertiefung (4) einsetzbar ist.

6. Gehäuse oder Baugruppenträger nach Anspruch 5, wobei die Vorderseite der montierten Abdeckplatte (2) bündig ist mit der Umrandung (3) oder gegenüber der Umrandung (3) versenkt angeordnet ist.

7. Gehäuse oder Baugruppenträger nach einem der vorangehenden Ansprüche, wobei das Formteil Teil der Umrandung (3) ist und/oder als abgewinkeltes Abdeckblech (8) mit Kontaktstellen (7) ausgebildet ist.

8. Gehäuse oder Baugruppenträger nach einem der vorangehenden Ansprüche, wobei die Kontaktstellen (7) des Formteils federnd ausgebildet sind.

9. Gehäuse oder Baugruppenträger nach einem der vorangehenden Ansprüche, wobei die Kontaktstellen (7) des Formteils als Noppen und/oder als vorstehende Teile und/oder als vorstehende Teile mit Noppen ausgebildet sind.

10. Gehäuse oder Baugruppenträger nach Anspruch 8, wobei die Kontaktstellen (7) des Formteils derart freigestanzt sind, dass eine Federwirkung erzielt wird.
